# EUROPEAN PATENT APPLICATION

(11) **EP 2 339 621 A2**
(43) Date of publication of application: **29.06.2011**
(21) Application number: 10170201.7
(22) Date of filing: 20.07.2010
(51) Int. Cl.: H01L 23/427, H01L 21/48

(54) **Method for flattening a heat dissipating tube and device for performing the same**

(30) Priority: 24.12.2009 TW 098144735
(71) Applicant: Chen, Shyh-Ming, Taipei County (TW)
(72) Inventor: Chen, Shyh-Ming, Taipei County (TW)
(74) Representative: Lang, Christian

(57) **Abstract**

A method for flattening a part of a heat dissipating tube which is embedded in a trench of a heat dissipating body and protrudes from a heat dissipating body. The method comprises the steps of: pressing a part of the heat dissipating tube protruded from the trench of the base by using a pressing unit. A device for performing the method is also disclosed. The device comprising: a retainer for retaining the heat dissipating body, and the heat dissipating tube being installed in a trench of the heat dissipating body; and a pressing unit capable of moving through the retainer for pressing a protruded portion of the heat dissipating tube protruded from the trench.

## Description

### FIELD OF THE INVENTION

The present invention relates to a method for flattening a part of a heat dissipating tube which is embedded in a trench of a heat dissipating body and protrudes from a heat dissipating body and a device for performing the same.

### BACKGROUND OF THE INVENTION

Heat dissipation is a main concern in electronic industry. Generally, heat dissipation base (a lump sheet or a lump block) and a heat dissipating fin set is used for dissipating heat. Further heat dissipating tube is used for enhancing the effect for dissipating heat. The heat dissipating tube is combined with the heat dissipating base or the heat dissipating fin set.

Generally, the heat dissipating tube is embedded in a trench of the base or the heat dissipating fin set. As a result, a part of the heat dissipating tube protrudes from the trench, while this will reduce the effect in heat dissipation. Thus, it is necessary to flat the part so as to have better heat dissipation effect.

Conventionally, heat dissipation tube is punched for flattening. However, the end of a punching block is a plane and the surface of the heat dissipating fin tube is an arc surface. The interior of the heat dissipating tube is filled with fluid. The punching operation will generate concave portion and thus after punching, the punching area of the heat dissipating tube is not flat so that the performance in heat dissipation is bad.

In one prior art, the punching operation is performed in two stages for flattening. A first punching operation serves to press the protruded portion of the heat dissipating tube so that the portion is embedded into the trench of the heat dissipating body. Then a second punching operation is performed. At this stage, the heat dissipating fin set is punched to be flushed with the surface of the heat dissipating body so as to have a better performance in heat dissipation.

However, in the above mentioned process, the process is tedious and complicated. Furthermore, the cost is high and the manufacturing process is low. Furthermore, the punching process will induce the copper power adhered on the wall of the heat dissipating tube to fall out so as to affect the heat dissipation performance.

### SUMMARY OF THE INVENTION

The object of the present invention is to provide a method for flattening a part of a heat dissipating tube which is embedded in a trench of a heat dissipating body and protrudes from a heat dissipating body and further the present invention provides a device for performing the method so that the heat source adhered to the heat dissipating body has a preferred heat dissipation effect.

To achieve the above object, the present invention provides a method for flattening a part of a heat dissipating tube which is embedded in a trench of a heat dissipating body and protrudes from a heat dissipating body. The method comprises the steps of: pressing a part of the heat dissipating tube protruded from the trench of the base by using a pressing unit.

Moreover, the present invention provides a device for flattening a heat dissipating tube which is combined with a heat dissipating body. The device comprises: a retainer for retaining the heat dissipating body, and the heat dissipating tube being installed in a trench of the heat dissipating body; and a pressing unit moving through the retainer for pressing a protruded portion of the heat dissipating tube protruded from the trench.

The various objects and advantages of the present invention will be more readily understood from the following detailed description when read in conjunction with the appended drawings.

### BRIEF DESCRIPTION OF THE DRAWINGS

Fig. 1 is a schematic view showing the heat dissipating body with a heat dissipating tube of the present invention before the heat dissipating tube is flattened;
Fig. 2 is a schematic view showing the heat dissipating body with a heat dissipating tube of the present invention after the heat dissipating tube is flattened;
Fig. 3 is a schematic view showing that a roller is used to flatten a heat dissipating tube according to the present invention before the heat dissipating tube is flattened;
Fig. 3-1 is a schematic view showing that a roller is used to flatten a heat dissipating tube according to the present invention after the heat dissipating tube is flattened;
Fig. 4 is a schematic view showing that a T shape rod is used to flatten a heat dissipating tube according to the present invention before the heat dissipating tube is flattened;
Fig. 4-1 is a schematic view showing that another T shape rod is used to flatten a heat dissipating tube according to the present invention before the heat dissipating tube is flattened;
Fig. 5 shows that two sides of the trench are protruded before the heat dissipating tube is flattened;
Fig. 5-1 shows that the protruded two sides of the trench illustrated in Fig. 5 are flattened according to the present invention;
Fig. 6 shows that the present invention is applied to a heat dissipating fin set before the heat dissipating tube is not flattened;
Fig. 7 shows that the protruded portions of the heat dissipating tubes in Fig. 6 are flattened;
Fig. 8 is a schematic view showing that a roller is used to flat a heat dissipating tube according to the present invention before the heat dissipating tube is flattened, wherein the heat dissipating tube is embedded into a heat dissipating tube;
Fig. 8-1 is a schematic view showing that a roller is used to flat a heat dissipating tube according to the present invention after the heat dissipating tube is flattened, wherein the heat dissipating tube is embedded into a heat dissipating tube;
Fig. 9 is a schematic view showing that a T shape rod is used to flat a heat dissipating tube according to the present invention before the heat dissipating tube is flattened, wherein the heat dissipating tube is embedded into a heat dissipating tube;
Fig. 9-1 is a schematic view showing that another T shape rod is used to flat a heat dissipating tube according to the present invention before the heat dissipating tube is flattened, wherein the heat dissipating tube is embedded into a heat dissipating tube;
Fig. 10 shows that two sides of the trench are protruded before the heat dissipating tube is flattened, wherein the heat dissipating tube is embedded into a heat dissipating tube;
Fig. 10-1 shows that the protruded two sides of the trench illustrated in Fig. 5 are flattened according to the present invention, wherein the heat dissipating tube is embedded into a heat dissipating tube;
Fig. 11 is a schematic view showing another embodiment of the present invention;
Fig. 12 is a schematic view showing another embodiment of the present invention;
Fig. 13 is a schematic view showing a further embodiment of the present invention;
Fig. 14 is a schematic view showing yet an embodiment of the present invention;
Fig. 15 is a schematic view showing the operation of the present invention;
Fig. 16 is a schematic view showing the operation of another embodiment of the present invention; and
Fig. 17 shows that the protruding portion of the heat dissipating tubes in Fig. 16 are flattened.

### DETAILED DESCRIPTION OF THE INVENTION

In order that those skilled in the art can further understand the present invention, a description will be provided in the following in details. However, these descriptions and the appended drawings are only used to cause those skilled in the art to understand the objects, features, and characteristics of the present invention, but not to be used to confine the scope and spirit of the present invention defined in the appended claims.

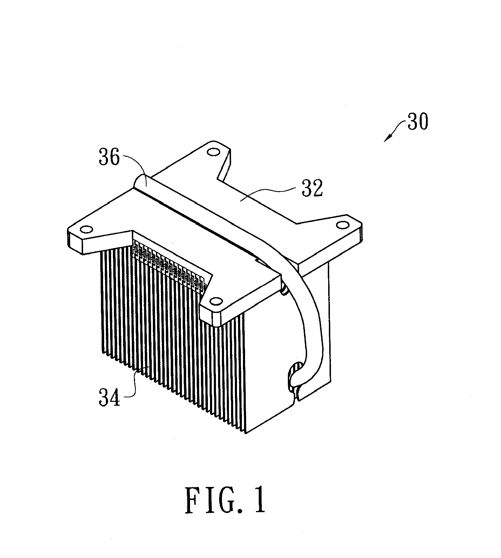

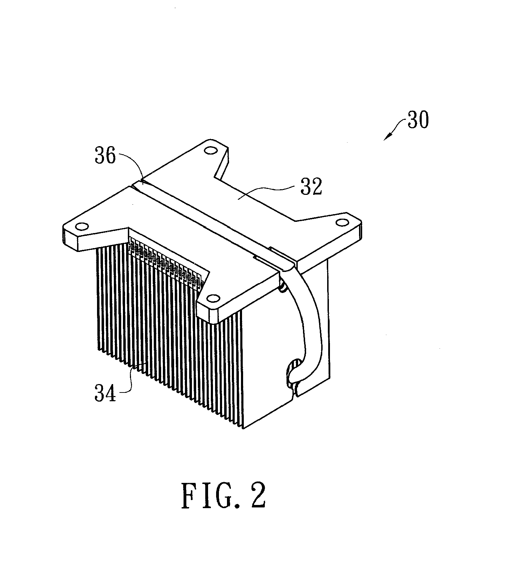

Referring to Fig. 1, a general structure for the heat dissipating body 30 of the present invention is illustrated. The heat dissipating body 30 includes a base 32, a heat dissipating fin set 34 below the base 32 and a heat dissipating tube 36 passing through the heat dissipating fin set 34 and being embedded in a trench of the heat dissipating body 30 at an upper side of the heat dissipating body 30. The heat dissipating body 30 protrudes from an upper surface of the base 32. Referring to Fig. 2, it is illustrated that the heat dissipating tube 36 at an upper side of the base 32 is flattened to be flushed with the upper surface of the base 32.

In use, a heat source is adhered to the upper surface of the base 32 so that a flushed heat dissipating tube 36 adhered to the trench of the base 32 is beneficial for adhering the heat source.

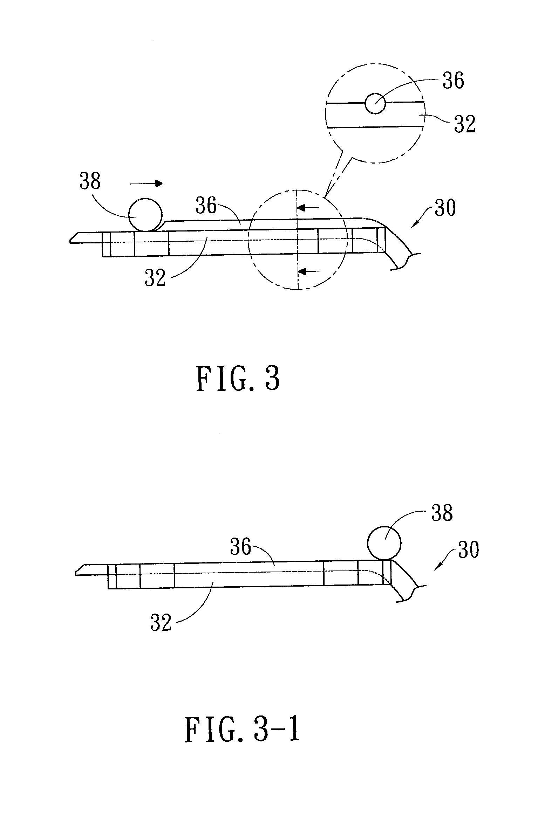

With reference to Figs. 3 and 3-1, the process for flattening the heat dissipating tube 36 is illustrated. Firstly, the heat dissipating tube 36 is placed in the trench at the upper surface of the base 32. It is illustrated that a part of the heat dissipating tube 36 protrudes from the trench of the upper surface of the base 32. It is not flat.

Next, a pressing unit 38 (in this embodiment, it is a roller) with a round cross section rolls through the upper surface so as to flatten the upper side of the heat dissipating tube 36 at the trench. However, the roller may be replaced by a pressing object which moves through the upper surface of the base 32 horizontally. However, the roller is a better form, which will cause that the stress to the heat dissipating tube 36 is minimized.

Punching operation is not a preferred way, since the punching will make the upper side of the heat dissipating tube 36 unflat.

After flattening the heat dissipating tube 36 at the upper surface, the upper side of the heat dissipating tube 36 at the upper surface can be polished or ground. The portions of the heat dissipating tube 36 contacting the base 32 and the heat dissipating fin set 34 are coated with heat conductive material, such as heat conductive glue, so as to increase the heat conductivity between the contact area.

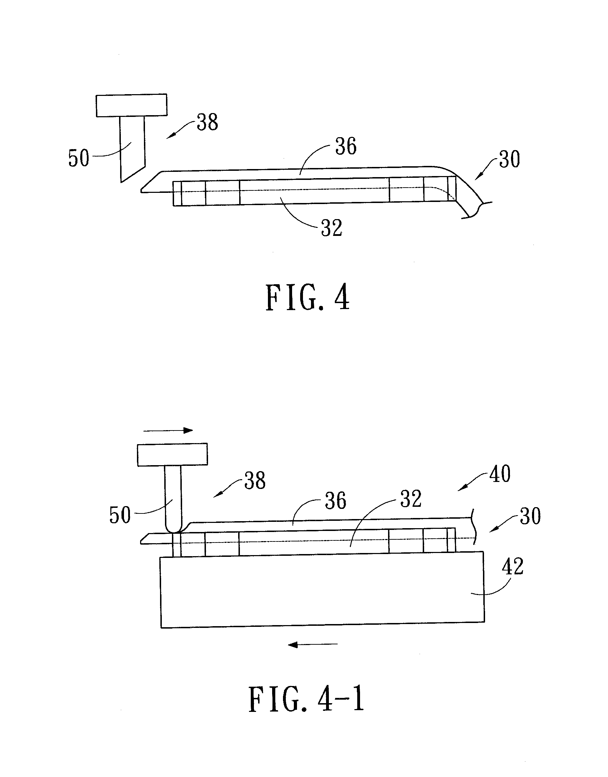

Referring to Figs. 4 and 4-1, it is illustrated that in this flattening process, in the overall structure 40, it contains a base 32 of a heat dissipating body 30 placed in a fixing seat 42. The fixing seat 42 may be for example, a platform or a clamping device, etc. The pressing unit 38 is used to flat the heat dissipating tube 36 by moving horizontally through the heat dissipating tube 36.

In this embodiment, the pressing unit 38 has a T shape cross section. In the example of Fig. 4, a lower pressing end 50 of the pressing unit 38 has an inclined surface. In operation, the inclined surface of the pressing end 50 is arranged along a longitudinal direction of the heat dissipating tube 36. By movement of the pressing end 50, the inclined surface of the pressing end will flatten the heat dissipating tube 36 at the upper surface of the base 32. However, in Fig. 4-1, it is illustrated that the end portion 50 of the pressing unit 38 may have another shape, such as a round tapered shape.

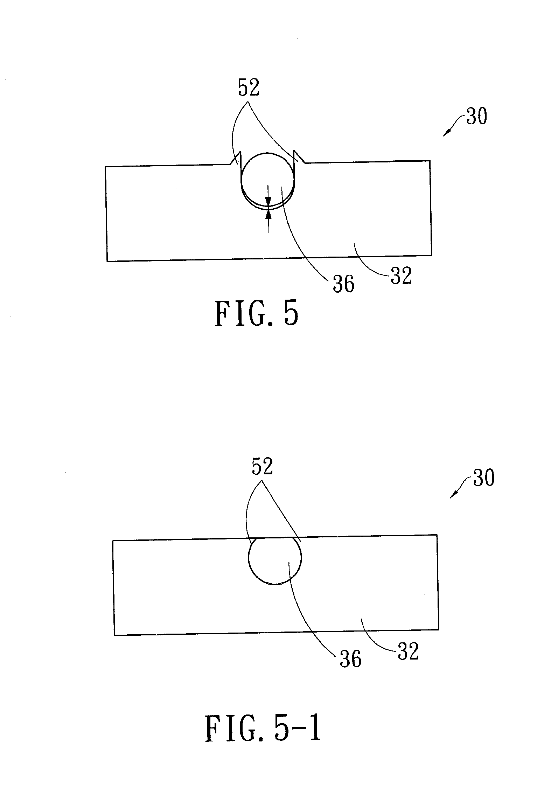

Referring to Figs. 5 and 5-1, it is illustrated that for the embodiment illustrated in Fig. 4, two sides 52 of the trench of the base 32 are protruded upwards. After pressing, two protruded sides 52 are flattened to cover an upper side of the heat dissipating tube 36 in the trench so that the heat dissipating effect is improved further.

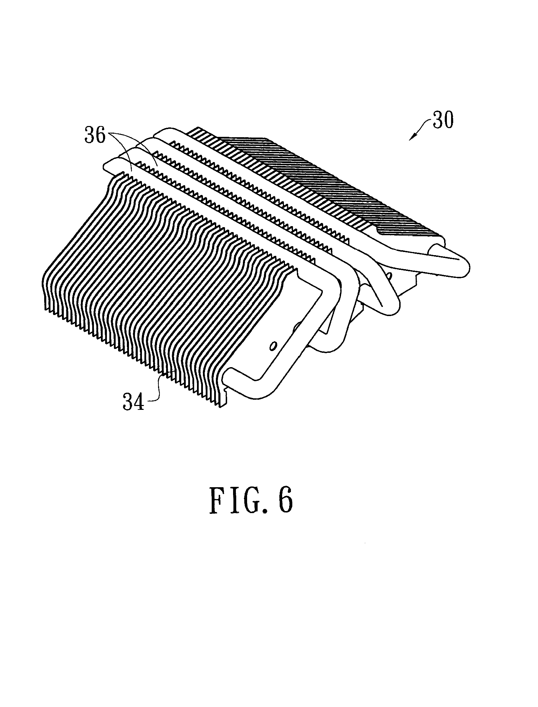

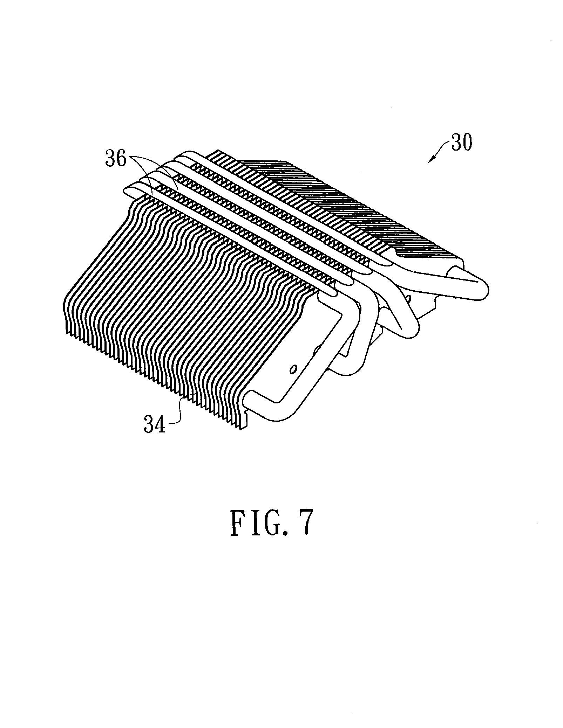

With reference to Fig. 6, it is illustrated that a plurality of heat dissipating tubes 36 are embedded into a heat dissipating fin set 34. An upper side of the heat dissipating fin set 34 is formed with a plurality of trenches for receiving parts of the plurality of heat dissipating tubes 36 in that the heat dissipating tubes 36 protrude from the trenches. Fig. 7 shows that the protruded portions of the heat dissipating tubes 36 are flattened. Thus, the upper sides of the heat dissipating fin set 34 can be used to bear a heat source.

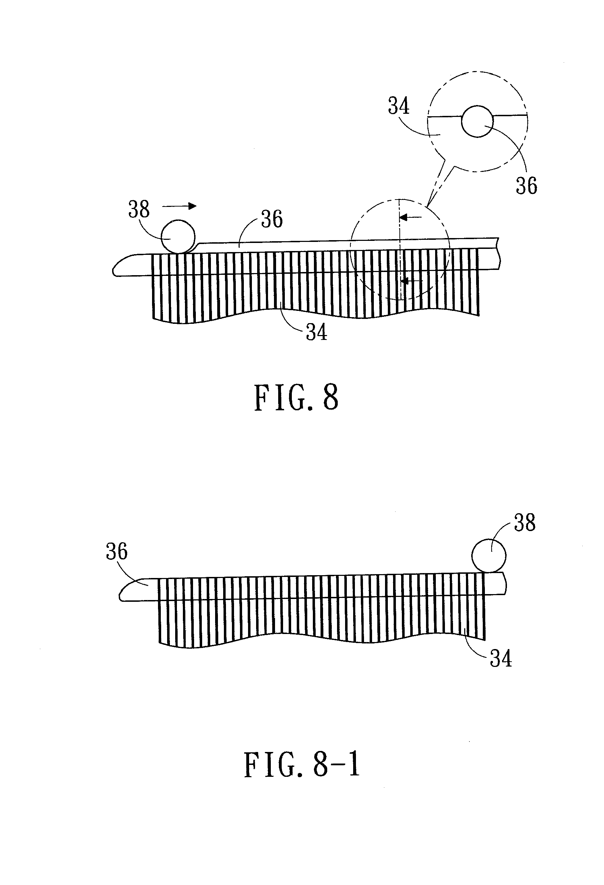

Figs. 8 and 8-1 show the way for flattening the heat dissipating tubes 36. A pressing unit 38 (in this embodiment, it is a roller with a round cross section) moves through the upper surface so as to flatten the upper side of the heat dissipating tube 36 at the trench. However, the roller may be replaced by a pressing object which moves through the upper surface of the base 32 horizontally. However, the roller is a better form, which will cause that the stress to the heat dissipating tube 36 is minimized.

Punching operation is not a preferred way, since the punching will make the upper side of the heat dissipating tube 36 unflat.

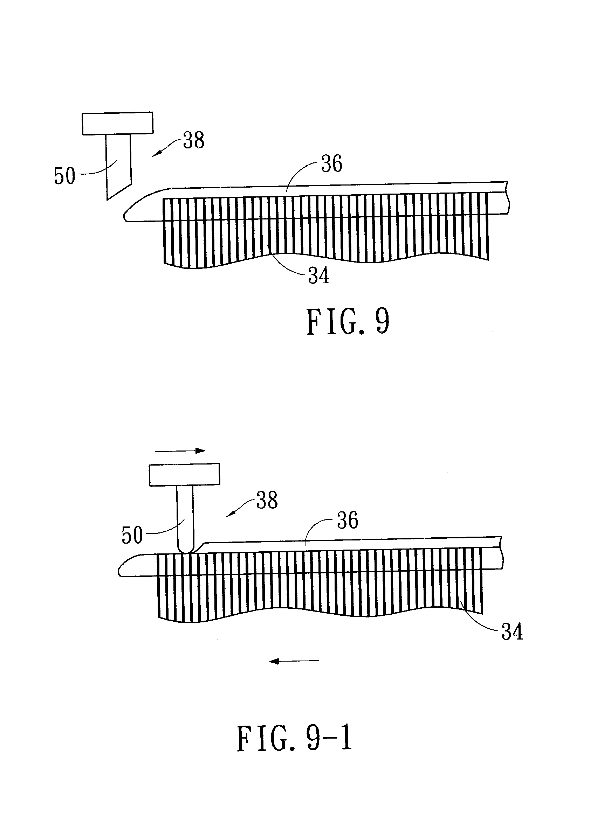

Referring to Figs. 9 and 9-1, another example for the structure in Fig. 8 is illustrated. The pressing unit 38 has a T shape cross section. A lower pressing end 50 of the pressing unit 38 has an inclined surface. In operation, the inclined surface of the pressing end 50 is arranged along a longitudinal direction of the heat dissipating tube 36. By movement of the pressing end 50, the inclined surface of the pressing end will flatten the heat dissipating tube 36 at the upper surface of the heat dissipating fin set 34. However, in Fig. 9-1, it is illustrated that the end portion 50 of the pressing unit 38 may have another shape, such as a round tapered shape.

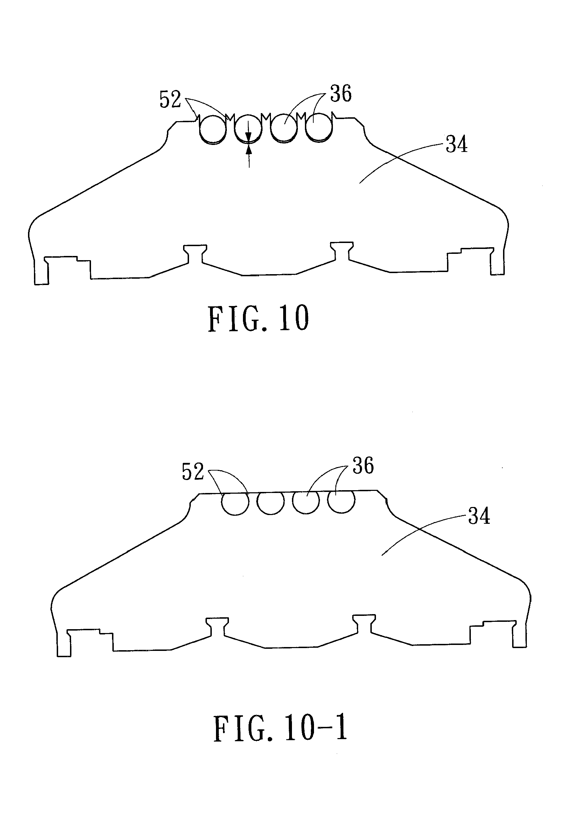

Referring to Figs. 10 and 10-1, it is illustrated that for the embodiment illustrated in Fig. 8, two sides 52 of the trench of the heat dissipating fin set 34 are protruded upwards. After pressing, two protruded sides 52 are flattened to cover an upper side of the heat dissipating tube 36 in the trench so that the heat dissipating effect is improved further.

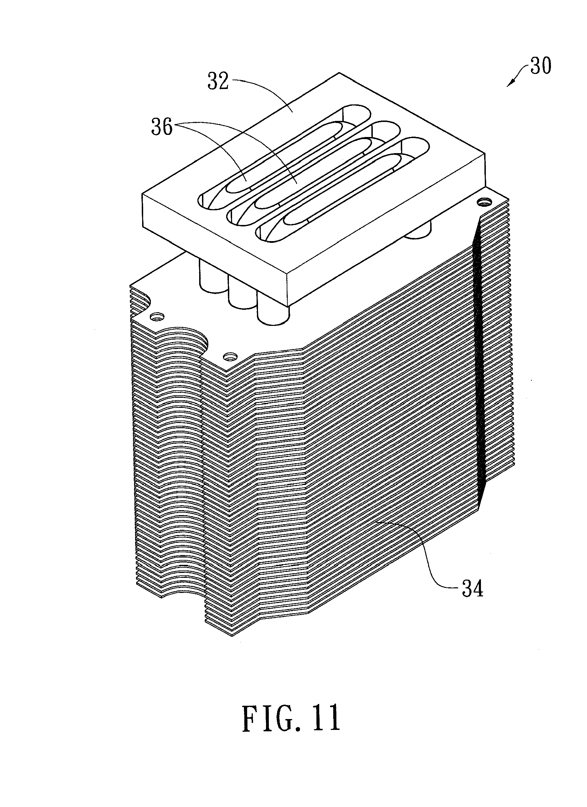

Referring to Fig. 11, another kind of heat dissipating body 30 is illustrated. In that, two ends of each heat dissipating tubes 36 are embedded into the heat dissipating fin set 34. A curved end of each heat dissipating tube 36 passes through a through hole of a base 32 and is clamped by two inner sides of the through hole of the base 32. A top end of the curved end of the heat dissipating tube 36 protrudes from the through hole of the base 32. However, the above mentioned way can be used to flatten the top end of the curved end of the heat dissipating tube 36. That is, a pressing unit is used to press the top end of the heat dissipating tube 36.

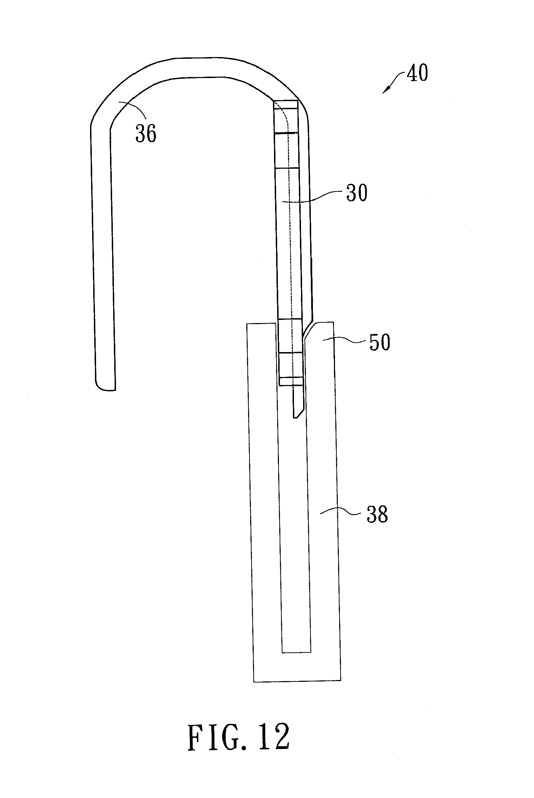

Referring to Fig. 12, in the manufacturing structure 40, it is illustrated that the pressing unit 60 serves to press the heat dissipating tube 36 and the heat dissipating body 30 from upper side so that the pressing unit 38 moves horizontally. The pressing unit 38 has a pressing end 50 which has an inclined surface for compressing the heat dissipating tube 36.

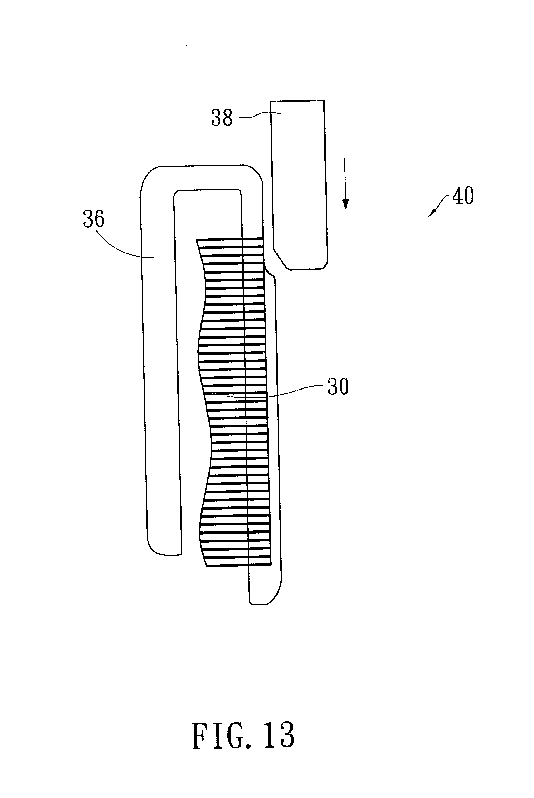

Referring to Fig. 13, the pressing unit 38 vertically presses the heat dissipating tube 36 to move horizontally. The pressing unit 38 has a predetermined volume. The vertically pressing has a preferred stability in operation. A contact surface of the pressing unit 38 for contacting the heat dissipating tube 36 is an inclined surface for pressing the heat dissipating tube 36.

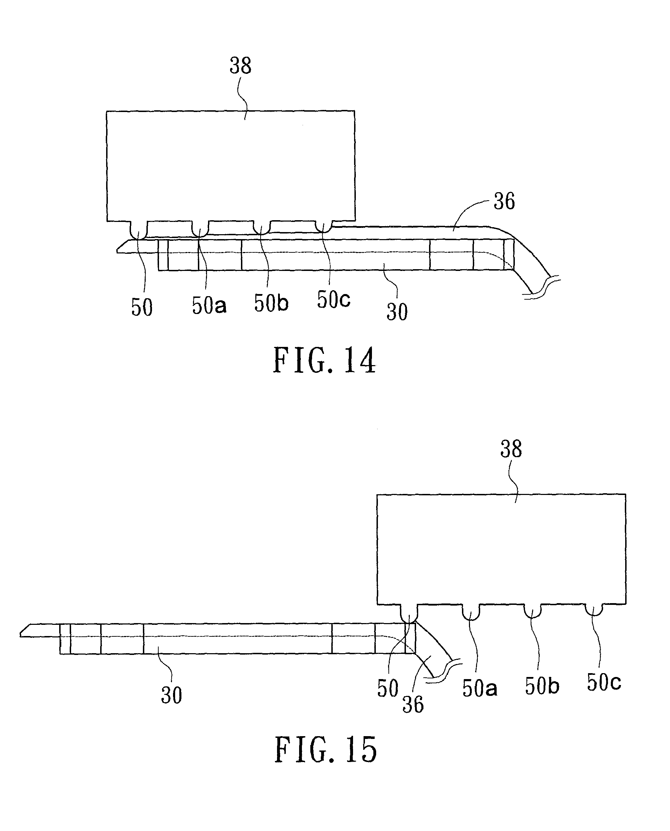

Referring to Figs. 14 and 15, it is illustrated that the pressing unit 38 approaches to the heat dissipating body 30 and presses the heat dissipating tube 36 horizontally. The pressing unit 38 includes at least two pressing ends, as it is illustrated in the drawings, the pressing ends are 50, 50a, 50b, and 50c which are arranged along a descending sequence. That is, with respect to the heat dissipating tube 36, the pressing end 50 is located to be higher that the heat dissipating tube 36, the pressing ends 50a, 50b are lower that the pressing end 50. The pressing end 50c is exactly at an optimum position which causes that the heat dissipating tube 36 is flushed to the heat dissipating body 30. By above mentioned features, movements of the pressing ends 50, 50a, 50b and 50c will press the heat dissipating tube 36. After the pressing unit 38 presses it completely, the protruding portion of the heat dissipating tube will be flushed. Thus the heat dissipating tube 36 deforms step by step. Undesired concave deformation will be reduced and the copper powder on the inner wall of the heat dissipating tube 36 will not fall down.

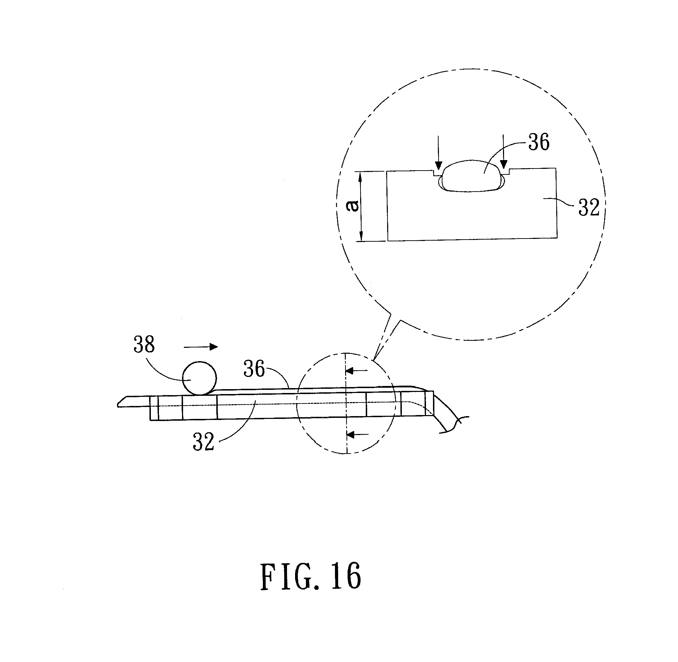

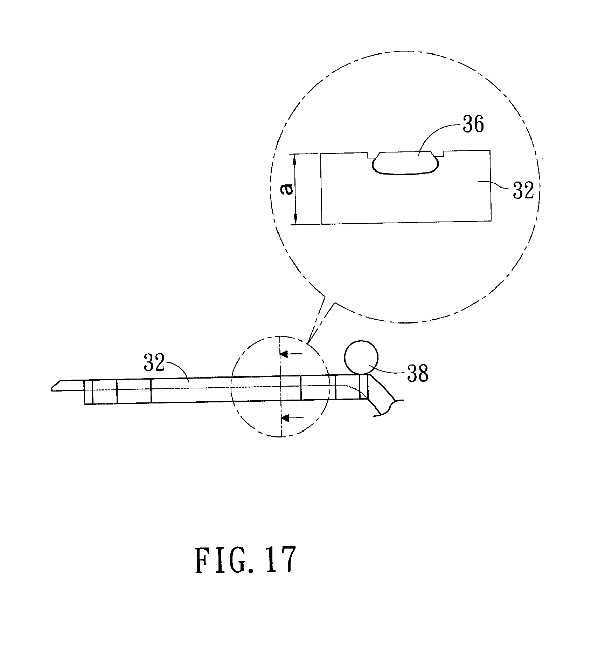

Please refer to Figs. 16 and 17, which show another preferred embodiment of the invention. The trench of the base 32 is embedded by a heat dissipating tube with an oval cross-section 36 and an upper part of the heat dissipating tube 36 protrudes from an upper surface of the base 32. The protruded part of the heat dissipating tube 36 is pressed by the roller type pressing unit 38 so as to flatten the upper part of the heat dissipating tube 36 at the trench and tightly connect with the base 32.

The present invention is thus described, it will be obvious that the same may be varied in many ways. Such variations are not to be regarded as a departure from the spirit and scope of the present invention, and all such modifications as would be obvious to one skilled in the art are intended to be included within the scope of the following claims.

## Claims

1. A method for flattening a part of a heat dissipating tube which is embedded in a trench of a heat dissipating body and protrudes from the heat dissipating body; comprising the steps of:
pressing a part of the heat dissipating tube protruded from the trench of the base by using a pressing unit.

2. The method as claimed in claim 1, wherein the pressing unit moves through the protruded part of the heat dissipating tube horizontally along a longitudinal direction of the trench.

3. The method as claimed in claim 1, wherein two sides of the trench are protruded upwards, after pressing, the two protruded sides will enclose the heat dissipating tube.

4. The method as claimed in claim 1, further comprising the step of performing a surface process to the surface of the heat dissipating tube.

5. A device for flattening a heat dissipating tube which is combined with a heat dissipating body, comprising:
a retainer for retaining the heat dissipating body, and the heat dissipating tube being installed in a trench of the heat dissipating body; and
a pressing unit capable of moving through the retainer for pressing a protruded portion of the heat dissipating tube protruded from the trench.

6. The device as claimed in claim 5, wherein the heat dissipating body is a heat dissipating fin set.

7. The device as claimed in claim 5, wherein the pressing unit moves through the protruded part of the heat dissipating tube horizontally along a longitudinal direction of the trench.

8. The device as claimed in claim 5, wherein the pressing unit is a roller.

9. The device as claimed in claim 5, wherein the pressing unit is a

10. The device as claimed in claim 5, wherein the pressing unit has a round tapered end.

11. The device as claimed in claim 5, wherein two sides of the trench are protruded upwards, after pressing, the two protruded sides will enclose the heat dissipating tube.

12. The device as claimed in claim 5, wherein a combination surface between the heat dissipating tube and the trench is coated with a layer of heat conductive glue.

13. The device as claimed in claim 5, wherein the pressing unit has a plurality of pressing ends which are arranged along a descend sequence along a direction toward the heat dissipating tube.

14. The device as claimed in claim 5, wherein the heat dissipating tube has an oval cross-section.
